# EUROPEAN PATENT SPECIFICATION

(11) **EP 0 410 423 B1**
(45) Date of publication and mention of the grant of the patent: **25.10.1995**
(21) Application number: 90114269.5
(22) Date of filing: 25.07.1990
(51) Int. Cl.: G05F 1/577, G05F 1/569

(54) **Multiple power supply system**
Mehrfachstromversorgungssystem
Système multiple d'alimentation

(30) Priority: 25.07.1989 JP 191834/89
(43) Date of publication of application: 30.01.1991
(73) Proprietor: KABUSHIKI KAISHA TOSHIBA, Kawasaki-shi, Kanagawa-ken 210 (JP)
(72) Inventor: Imanishi, Kazuo, c/o Intellectual Property Div., Minato-ku, Tokyo 105 (JP)
(74) Representative: Lehn, Werner, Dipl.-Ing.

(56) References cited:
- EP-A- 0 191 740
- US-A- 3 504 272
- US-A- 4 009 420
- PATENT ABSTRACTS OF JAPAN, vol. 11, no. 72 (P-554)[2519], 5th March 1987 & JP-A-61 234 412 (OKI ELECTRIC IND. CO., LTD) 18-10-1986
- PATENT ABSTRACTS OF JAPAN, vol. 10, no. 152 (P-462)[2208], 3rd June 1986 & JP-A-61 5322 (NIPPON DENKI K.K.) 11-01-1986

## Description

The present invention relates to a power monolithic integrated circuit controlled by a microcomputer external to said monolithic integrated circuit.

For example, a conventional audio set comprises a plurality of independent sections, e.g., a tuner section and an amplifier section, and has independent power supplies corresponding to these sections.

On the other hand, recently, microcomputers are generally used and electronic equipment is generally systematically controlled by the microcomputers. For example, a power supply monolithic integrated circuit (a system-power supply monolithic integrated circuit) is known.- The power supply monolithic integrated circuit is a system power-supply wherein a decoder for decoding an output signal from a microcomputer-and a plurality of stabilizing power supply circuits selectively controlled by the decoder are arranged on a single chip. This system power supply may be used for an audio set.

In this circuit, one of the plurality of power supply circuits is used for a microcomputer power supply. A protective circuit (such as a current limiter) is incorporated in the circuit for detecting an abnormality when a surge voltage is applied to the system power supply or an abnormality occurs in the decoder section or one of the power supply circuits, and for cutting off a bias of the entire system power supply (that is, for controlling the decoder and each power supply circuit in an OFF state).

In the system power supply described above, when the surge voltage is applied, the protective circuit detects this surge voltage and cuts off the bias of the entire system power supply so as to be able to protect the electronic equipment controlled by the microcomputer. When output short-circuiting occurs in one of the plurality of power supply circuits, the protective circuit detects the short-circuiting and cuts off the bias of the entire system power supply so as not to damage other sections.

In other conventional system power supply described above, however, in a control operation of the protective circuit, since the microcomputer power supply is also controlled in an OFF state, an operation of the microcomputer stops and the entire electronic equipment abnormally operates. In order to reset the power supply of the entire system to return to a normal operation state after the abnormal state is cancelled, it is necessary to reset the microcomputer.

From Patent Abstracts of Japan, Volume 10, No. 152 (P-462) [2208], 3rd June 1986, a power supply control system is known which includes protective circuit means for controlling a plurality of power supplies to an off state in case that an abnormality occurs.

From US 4 009 420 a solid state control circuit for controlling the application of an AC voltage to a plurality of power supplies is known. The solid state control circuit includes a solid state relay means in series with a plurality of load circuits, and the relay means is switched off in response to a power supply failure.

As described above, in a control operation of the protective circuit, since the conventional power supply monolithic integrated circuit controls the microcomputer power supply in an OFF state, the entire electronic equipment controlled by the microcomputer abnormally operates, resulting in inconvenience.

The present invention has been made to overcome the above drawbacks, and has as its object to provide a power supply monolithic integrated circuit capable of a continuous operation of a microcomputer in a control operation when a protective circuit detects an abnormality in a circuit section except for a microcomputer power supply, and capable of a continuous operation of a section of electronic equipment controlled by the microcomputer.

This object is solved by a power supply monolithic integrated circuit controlled by a microcomputer external to said monolithic integrated circuit,
characterized by comprising:
- a microcomputer power supply for supplying power to said external microcomputer;
- a plurality of power supplies other than said microcomputer power supply ;
- decoding means for decoding signals from said external microcomputer and outputting power supply control signals to said power supplies other than said microcomputer power supply; and
- first protective circuit means for detecting a first abnormality in any one of said plurality of power supplies other than said microcomputer power supply , and for controlling said plurality of power supplies other than said microcomputer power supply to an OFF state in response to the detected first abnormality.

A power supply monolithic integrated circuit according to the present invention is characterized by comprising a microcomputer power supply, a decoder for decoding a signal from an external microcomputer, a plurality of power supplies selectively controlled by an output of the decoder, and a first protective circuit for detecting an abnormality in any one of the plurality of power supplies, and for controlling the plurality of power supplies to an OFF state.

In a control operation when the first protective circuit detects an abnormality in a circuit section except for the microcomputer power supply, since the microcomputer power supply is independent of the control of the first protective circuit, the microcomputer can continuously receive an electric power so as to continue the operation. Therefore, the electronic equipment controlled by the microcomputer can continue the operation except for the section associated with the power supply OFF-controlled by the first protective circuit.

This invention can be more fully understood from the following detailed description when taken in conjunction with the accompanying drawings, in which:
Fig. 1 is a block diagram showing an arrangement of an embodiment of the present invention;
Fig. 2A is a circuit diagram showing a practical circuit arrangement of the main part of the embodiment shown in Fig. 1;
Fig. 2B shows a circuit diagram to be connected to the power supply circuit of Fig. 2A; and
Fig. 3 is a block diagram showing an arrangement of another embodiment of the present invention.

Embodiments of the present invention will be described in detail with reference to the accompanying drawings hereinafter.

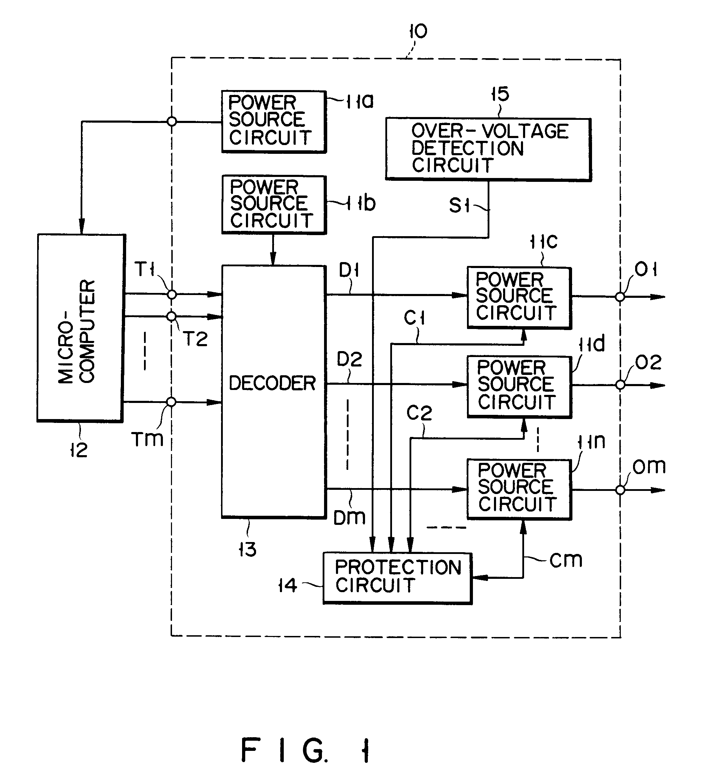

Fig. 1 shows a system power supply for an audio set. A block 10 shown by a broken line is a power supply monolithic integrated circuit formed on a single semiconductor substrate. In the integrated circuit 10, a plurality of power supply circuits 11a, 11b, 11c, 11d, ..., 11n are formed independently of each other. Among these, the power supply circuit 11a is used as a power supply for a microcomputer 12 arranged outside the integrated circuit 10, and the power supply circuit 11b is used as the power supply for a decoder 13. A plurality of bits of power supply designating outputs of the microcomputer 12 are supplied to the decoder 13 in the integrated circuit 10 through terminals T1, T2, ..., Tm and are decoded by the decoder 13. Decode outputs D1, D2, ..., Dm from the decoder 13 are supplied to the power supply circuits 11c, 11d, ..., 11n as power supply selection signals, respectively. Output voltages from the power supply circuits 11c, 11d, ..., 11n which receive the power supply selection signals are supplied from output terminals O1, O2, ..., Om to, for example, a tuner section, an amplifier section, and a CD player section, in the audio set.

Operation state detectors which will be described later are arranged in the power supply circuits 11c, 11d, ..., 11n, respectively. Detection signals from the operation state detectors are sent to a protective circuit 14 through control lines C1, C2, ..., Cm. The control lines C1, C2, ..., Cm include paths for transmitting protection signals from the protective circuit 14 to the power supply circuits 11c, 11d, ..., 11n. An output from the power supply circuit which receives the protection signal is cut off. In this embodiment, since the detection signals from the power supply circuits 1lb, 11c, ..., 11n are supplied to an OR circuit in the protective circuit 14, even if an abnormal detection signal is generated by any one of the power supply circuits, an output from the OR circuit can be obtained. The output from the OR circuit is input to a protection signal output circuit in the protective circuit 14, and the protection signal is commonly output to the power supply circuits 11c, 11d, ..., 11n except for the power supply circuits 11a and 11b.

In the integrated circuit 10, an overvoltage detector 15 is arranged as needed. When a surge voltage is generated by an external power supply voltage supplied to the integrated circuit 10, the overvoltage detector 15 detects the surge voltage to transmit it with detection signals of the power supply circuits 11c, 11d, ..., 11n to the input side of the OR circuit in the protective circuit 14 through a line S1.

In the system power supply 10 described above, for example, when the surge voltage is applied, since the surge voltage is detected by the overvoltage detector 15 and is sent to the protective circuit 14, and all the power supply circuits 11c, 11d, ..., 11n except for the power supply circuits 11a and 1lb for the power supply for the decoder 13 and the microcomputer 12 are controlled in an OFF state at once, the audio set sections connected to the OFF-controlled power supply circuits 11c, 11d, ..., 11n are protected. In addition, when an output abnormality including output short-circuiting occurs in one or a plurality of the power supply circuits 11c, 11d, ..., 11n except for the power supply circuits for the microcomputer 12 and the decoder 13, the protective circuit 14 detects the abnormal output and the power supply circuits 11c, 11d, ..., 11n are OFF-controlled by the protective circuit 14 so as not to adversely affect other power supply circuits of the audio set.

In such a control operation of the protective circuit 14, since the power supply circuits 11a and 11b for the microcomputer 12 and the decoder 13, respectively, are independent of the control of the protective circuit 14, the microcomputer 12 and the decoder 13 can continuously receive an electric power so as to continue their operations.

The audio set controlled by the microcomputer 12 can therefore continue the operations of its sections except for a section connected to the power supply circuit OFF-controlled by the protective circuit 14. In other words, the entire audio set never abnormally operates or stops, or it is not necessary to reset the microcomputer 12 to return to a normal operation state by resetting the power supply circuits of the entire system after an abnormal state is canceled.

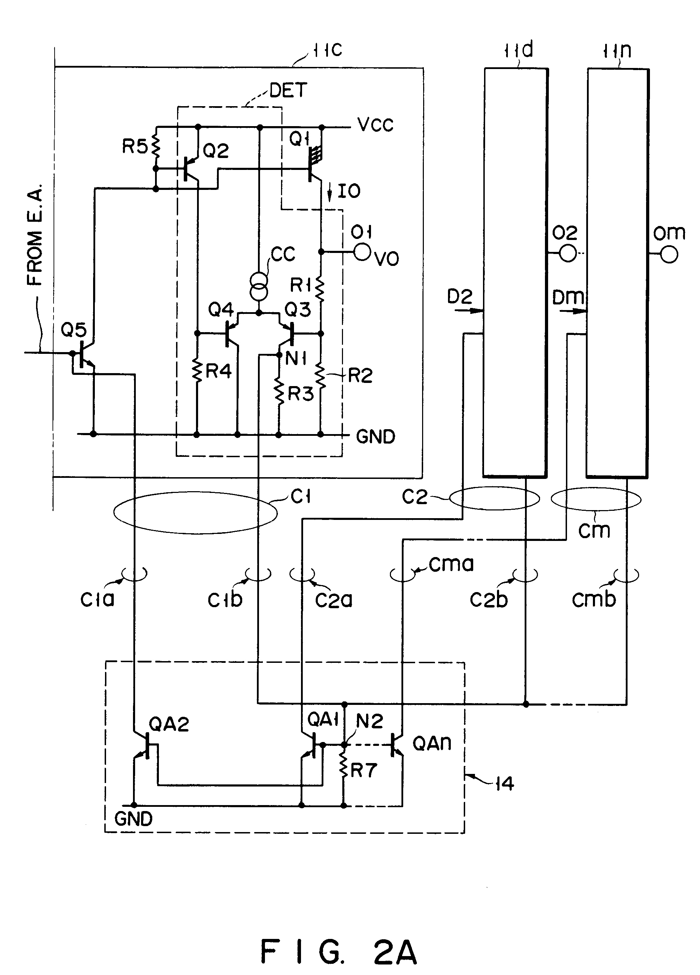

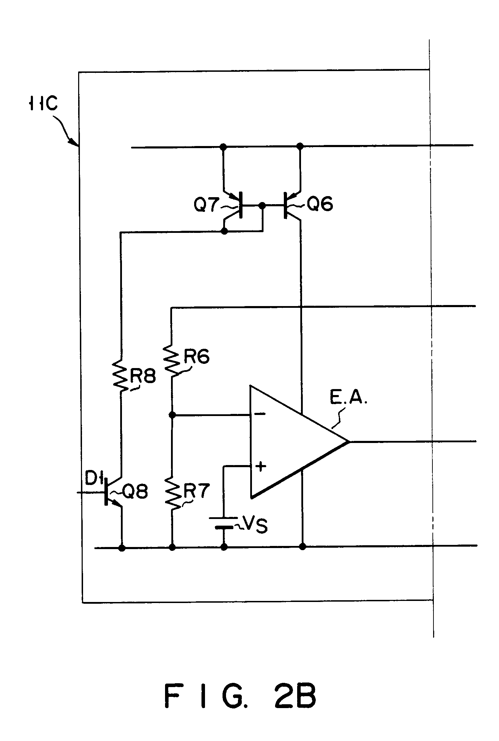

Practical circuit arrangements and operations of the power supply circuits 11c, 11d, ..., 11n and the protective circuit 14 shown in Fig. 1 will be described in detail with reference to Figs. 2A and 2B. In Figs. 2A and 2B, the power supply circuit 11c comprises transistors Q1, Q2, Q3, Q4, Q5, Q6, Q7 and Q8 connected between a power supply line Vcc and GND. The transistors Q2 to Q4 constitute a detector DET, and the collector of the transistor Q5 is commonly connected to the bases of the transistors Q1 and Q2.

The transistor Q1 is an output transistor having a multi-emitter arrangement. The collector of the transistor Q1 is connected to an output terminal O1. The transistor Q2 forms a current mirror circuit with the transistor Q1. These transistors Q1 and Q2 are driven by the driver transistor Q5. The decode output D1 from the decoder 13 shown in Fig. 1 is supplied to the base of the transistor Q8, and the protection signal from the protective circuit 14 is supplied to the base of the transistor Q5 through a protective line C1a in the control line C1.

An output voltage VO is fed back to an inversion terminal of an error amplifier E.A. through two serial resistors R6 and R7. A D.C. reference voltage is supplied to a non-inversion terminal of the amplifier E.A. from a D.C. power source Vs. An output of the amplifier E.A. is supplied to the base of transistor Q5. The emitter of the transistor Q8 is grounded and the collector thereof is connected, via a resistor R8, to the collector of the transistor Q7 and the common base node of the transistors Q6 and Q7. The base of the transistor Q8 is connected to receive the decoder output D1 of the decoder 13.

In the power supply circuit 11c, when the transistor Q8 is turned on in response to the decoder output D1, a current mirror circuit constituted by the transistors Q6 and Q7 is driven and the error amplifier E.A. is also driven. As a result, the output of the amplifier E.A. is supplied to the base of the transistor Q5 to bring the power supply circuit 11c in an ON state. In the circuit 11c, the output voltage VO is represented as follow:$\text{VO =} \frac{\text{R6 + R7}}{\text{R7}} \text{· Vs}$

The transistors Q3 and Q4 serve as a comparator driven by a constant current source CC. As an input to be a reference to the comparator, a voltage generated across a resistor R4 by a current flowing through the transistor Q2 of the current mirror circuit is used. The voltage is supplied to the base of the transistor Q4. The voltage to be compared by the comparator is an output voltage VO at the output terminal O1. The output voltage VO is detected by the resistance ratio between resistors R1 and R2, supplied to the base of the transistor Q3, and compared with the reference voltage at the base of the transistor Q4.

An output from the comparator constituted by the transistors Q3 and Q4 is extracted from a node between the collector of the transistor Q3 and a resistor R3, and commonly connected to the bases of transistors QA1, QA2, ..., QAm in the protective circuit 14. The emitters of the transistors QA1, QA2 ..., QAm are connected to a power supply line GND, and the bases of the transistors are connected to the power source line GND through a resistor R7. The collector of the transistor QA2 is connected to the base of the transistor Q5 through the protective line C1a.

Other power source circuits 11d to 11n are arranged in the same manner as the power source circuit 11c, and outputs from the detectors are commonly OR-connected to a node N2 through detection lines C2b to Cmb.

It is assumed that in the circuit shown in Figs. 2A and 2B, short-circuiting occurs at a section connected to the output terminal O1 of the power supply circuit 11c, for example, the tuner section. As a result, the voltage VO of the output terminal O1 is abruptly decreased, so that the base voltage of the transistor Q3 is decreased with respect to the reference voltage at the base of the transistor Q4. Thus, a large current flows into the resistor R3 through the transistor Q3, a voltage of the node N1 increases, and the transistors QA1 to QAn in the protective circuit 14 are turned on. As a result, the base voltage of the transistor Q5 is decreased to be set in a cut-off state, and the output transistor Q1 is cut off. The outputs from other power supply circuits 11d to 11n are also cut off.

The detector DET shown in Figs. 2A and 2B is arranged so as to be able to detect an overcurrent of an output in addition to detect the decrease in the output voltage VO. That is, the base voltage of the transistor Q3 can be represented by the following equation.$\text{VO × R2/(R1+R2) = (IO/N)·R4}$
where R1 to R4 represent resistances of the resistors R1 to R4, respectively; IO, a current flowing in the output transistor Q1; and N, an emitter area ratio between the transistors Q1 and Q2.

Therefore, from equation (2), the following equation can be obtained.$\text{VO/IO = {(R1+R2)/R2}·R4/N = constant}$
As a result, a change in current IO (overcurrent) can be detected as a change in voltage of the node N2 through a detection line C1b.

Note that, in Fig. 1, the output signal from the microcomputer 12 to the decoder 13 is not limited to parallel data shown in the figure, but can be serial data or other signals.

In the system power supply 10 in the above embodiment, in a control operation by the protective circuit 14, the abnormal operation or stop of the entire audio set is prevented. When an abnormality occurs in the power supply circuit 11a for the microcomputer, however, if the microcomputer 12 abnormally operates (overruns), the operation of the entire audio set which is erroneously controlled by the microcomputer 12 may be abnormal. The same problem arises in the decoder 13.

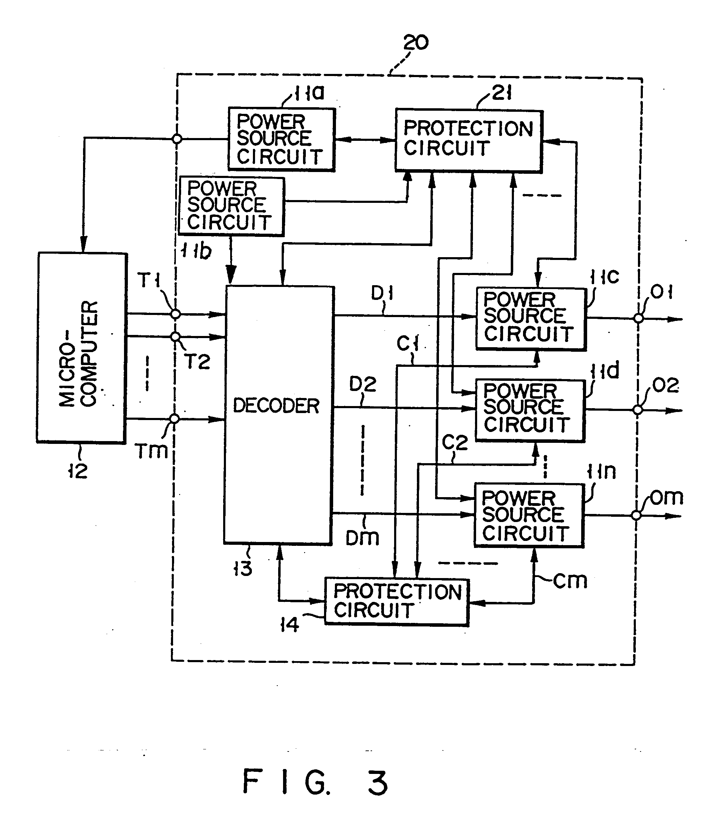

A system power supply 20 according to another embodiment of the present invention for solving this problem is shown in Fig. 3. The system power supply 20 is different from the system power supply 10 of the above embodiment in additionally comprising a protective circuit (such as a current limiter) 21 for detecting an abnormality when the abnormality occurs in the power supply 11a for the microcomputer and controlling all the power supply circuits 11a, 11b, ..., 11n and the decoder 13 in an OFF state. Other parts are essentially the same as in Fig. 1, and the same reference numerals as in Fig. 1 denote the same parts in Fig. 3.

In the above system power supply 20, the same effect as in the above embodiment can be obtained. In addition, when the protective circuit 21 detects an abnormality in the power supply circuit 11a for the microcomputer, the protective circuit 21 controls all the power supply circuits and the decoder 13 in an OFF state. Therefore, the power is not supplied to the tuner section, the amplifier section, and a microcomputer 12, so that the microcomputer does not abnormally operate, and the entire audio set does not abnormally operate.

As described above, by the power supply monolithic integrated circuit according to the present invention, in a control operation when the protective circuit detects an abnormality in the circuit section except for the power supply circuit for the microcomputer, the microcomputer can continue to operate, and the electronic equipment controlled by the microcomputer can continue partial operation.

In addition, by the power supply monolithic integrated circuit according to the present invention, if the second protective circuit detects an abnormality in the microcomputer power supply circuit, all the power supply circuits are controlled in an OFF state, so that the power is not supplied to each section of the electronic equipment and the microcomputer. Therefore, the microcomputer does not abnormally operate, and the entire electronic equipment does not abnormally operate either.

Reference signs in the claims are intended for better understanding and shall not limit the scope.

## Claims

1. A power supply monolithic integrated circuit controlled by a microcomputer external to said monolithic integrated circuit,
characterized by comprising:
- a microcomputer power supply (11a) for supplying power to said external microcomputer (12);
- a plurality of power supplies (11c to 11n) other than said microcomputer power supply (11a);
- decoding means (13) for decoding signals from said external microcomputer (12) and outputting power supply control signals to said power supplies (11c to 11n) other than said microcomputer power supply (11a); and
- first protective circuit means (14) for detecting a first abnormality in any one of said plurality of power supplies (11c to 11n) other than said microcomputer power supply (11a), and for controlling said plurality of power supplies (11a to 11n) other than said microcomputer power supply (11a) to an OFF state in response to the detected first abnormality.

2. A circuit according to claim 1,
characterised by further comprising second protective circuit means (21) for detecting a second abnormality in said microcomputer power supply (11a) and for controlling said microcomputer power supply (11a) and said power supplies (11c to 11n) other than said microcomputer power supply (11) in an OFF state in response to the detected second abnormality.

3. A circuit according to claim 1, characterized in that each of said plurality of power supplies (11c to 11n) comprises detecting means (DET) for detecting a change in output voltage, and said first protective circuit means (14) comprises OR means (N2) for receiving a detection signal from said detecting means (DET), and means (Q1 to Q5) for cutting off an output voltage of a corresponding power supply (11c) in response to an output from said OR means (N2).

4. A circuit according to claim 3, characterized in that said detecting means (DET) comprises a comparator (Q3, Q4) for comparing an output voltage with a reference voltage, and means (Q1) for outputting an output obtained from said comparator (Q3, Q4) in accordance with the change in output voltage as a detection signal to said first protective circuit (14).

5. A circuit according to claim 1,
characterized in that said circuit is incorporated in a power supply circuit.

## Patentansprüche

1. Monolithisch integrierter Stromversorgungsschaltkreis, der von einem externen Mikrocomputer gesteuert wird, gekennzeichnet durch:
- eine Mikrocomputerstromversorgung (11a) zum Liefern von Leistung an den externen Mikrocomputer (12);
- eine Vielzahl von anderen Stromversorgungen (11c bis 11n) neben der Mikrocomputerstromversorgung (11a);
- Decodereinrichtungen (13) zum Decodieren von Signalen von dem externen Mikrocomputer (12) und Ausgeben von Stromversorgungssteuersignalen an die Stromversorgungen (11c bis 11n) außer der Mikrocomputerstromversorgung (11a); und
- erste Schutzschaltkreiseinrichtungen (14) zum Erfassen einer ersten Anomalität in irgendeiner der Vielzahl von Stromversorgungen (11c bis 11n) außer der Mikrocomputerstromversorgung (11a), und zum Steuern der Vielzahl von Stromversorgungen (11a bis 11n) außer der Mikrocomputerstromversorgung (11a) in einen AUS-Zustand als Reaktion auf die erfaßte erste Anomalität.

2. Schaltkreis nach Anspruch 1, gekennzeichnet durch zweite Schutzschaltkreiseinrichtungen (21) zum Erfassen einer zweiten Anomalität in der Mikrocomputerstromversorgung (11a) und zum Steuern der Mikrocomputerstromversorgung (11a) und der Stromversorgungen (11c bis 11n) außer derMikrocomputerstromversorgung (11) in einen AUS-Zustand als Reaktion auf die erfaßte zweite Anomalität.

3. Schaltkreis nach Anspruch 1, dadurch gekennzeichnet, daß jede der Vielzahl von Stromversorgungen (11c bis 11n) Erfassungseinrichtungen (DET) zum Erfassen einer Veränderung der Ausgangsspannung umfaßt, und die erste Schutzschaltkreiseinrichtung (14) ODER-Einrichtungen (N2) zum Empfangen eines Erfassungssignals von den Erfassungseinrichtungen (DET) umfaßt, sowie Einrichtungen (Q1 bis Q5) zum Abschalten einer Ausgangsspannung einer entsprechenden Stromversorgung (11c) als Reaktion auf eine Ausgabe von den ODER-Einrichtungen (N2).

4. Schaltkreis nach Anspruch 3, dadurch gekennzeichnet, daß die Erfassungseinrichtung (DET) einen Komparator (Q3, Q4) zum Vergleichen einer Ausgangsspannung mit einer Referenzspannung umfaßt, sowie Einrichtungen (Q1) zum Ausgeben einer von dem Komparator (Q3, Q4) in Übereinstimmung mit der Änderung der Ausgangsspannung erhaltenen Ausgabe als ein Erfassungssignal an den ersten Schutzschaltkreis (14).

5. Schaltkreis nach Anspruch 1, dadurch gekennzeichnet, daß der Schaltkreis in einen Stromversorgungsschaltkreis eingegliedert ist.

## Revendications

1. Un circuit intégré, monolithique, d'alimentation de puissance électrique, commandé par un micro-ordinateur externe audit circuit intégré, monolithique,
caractérisé en ce qu'il comprend :
- une alimentation de puissance électrique (11a) de micro-ordinateur, pour fournir une puissance électrique audit micro-ordinateur (12) externe ;
- une pluralité d'alimentations de puissance électrique (11c à 11n), autres que ladite alimentation de puissance électrique (11a) de micro-ordinateur ;
- des moyens (13) de décodage, pour décoder des signaux provenant dudit micro-ordinateur (12) externe et émettre des signaux de commande d'alimentation de puissance électrique auxdites alimentations de puissance électrique (11c à 11n), autres que ladite alimentation de puissance électrique (11a) de micro-ordinateur ; et
- des premiers moyens (14) de circuit protecteur, pour détecter une première anomalie dans l'une quelconque des alimentations de puissance électrique de ladite pluralité d'alimentation de puissance électrique (11c à 11n), autres que ladite alimentation de puissance électrique (11a) de micro-ordinateur, et pour commander ladite pluralité d'alimentations de puissance électrique (11a à 11n), autres que ladite alimentation de puissance électrique (11a) de micro-ordinateur, à un état hors service, en réponse à la première anomalie détectée.

2. Un circuit selon la revendication 1,
caractérisé en ce qu'il comprend de plus des seconds moyens (21) de circuit protecteur, pour détecter une seconde anomalie dans ladite alimentation de puissance électrique (11a) de micro-ordinateur, et pour commander ladite alimentation de puissance électrique (11a) de micro-ordinateur et lesdites alimentations de puissance électrique (11c à 11n), autres que ladite alimentation de puissance électrique (11a) de micro-ordinateur, dans un état hors service, en réponse à la seconde anomalie détectée.

3. Un circuit selon la revendication 1, caractérisé en ce que chaque alimentation de puissance électrique de ladite pluralité d'alimentations de puissance électrique (11c à 11n) comprend des moyens de détection (DET), pour détecter un changement dans la tension d'émission, et en ce que lesdits premiers moyens (14) de circuit protecteur comprennent des moyens OU (N2), pour recevoir un signal de détection à partir desdits moyens de détection (DET), et des moyens (Q1 à Q5) pour couper une tension d'émission d'une alimentation de puissance électrique (11c) correspondante, en réponse à une émission à partir desdits moyens OU (N2).

4. Un circuit selon la revendication 3, caractérisé en ce que lesdits moyens de détection (DET) comprennent un comparateur (Q3, Q4), pour comparer une tension d'émission avec une tension de référence, et des moyens (Q1), pour émettre une émission, obtenue à partir dudit comparateur (Q3, Q4), en concordance avec le changement dans la tension d'émission, comme un signal de détection, audit premier circuit (14) protecteur.

5. Un circuit selon la revendication 1, caractérisé en ce que ledit circuit est incorporé dans un circuit d'alimentation de puissance électrique.
